# EUROPEAN PATENT APPLICATION

(11) **EP 4 832 287 A1**
(43) Date of publication of application: **28.10.2026**
(21) Application number: 26173746.4
(22) Date of filing: 21.04.2026
(51) Int. Cl.: H02H 9/04, H10D 89/60, H10W 42/60

(54) **MULTI-CHIP PACKAGE AND ELECTRONIC DEVICE HAVING THE SAME**

(30) Priority: 21.04.2025 KR 20250051666
(71) Applicant: LX Semicon Co., Ltd., Daejeon 34027 (KR)
(72) Inventor: LEE, Jae Hwan, 34027 Daejeon (KR); NAM, Jeong Kwon, 34027 Daejeon (KR)
(74) Representative: Ter Meer und Partner mbB

(57) **Abstract**

A multi-chip package according to one embodiment of the present disclosure includes a multi-chip package implemented by wire bonding a first chip and a second chip, wherein the first chip includes: a first power pin electrically connected to a voltage source that generates or supplies a first voltage; a second power pin electrically connected to a voltage source that generates or supplies a second voltage lower than the first voltage; and a third power pin electrically connected to the first power pin, and the first chip is configured to compare the first voltage supplied through the first power pin with a preset reference voltage, and based on the comparison result, is configured to supply the first voltage to the second chip or discharges the first voltage without supplying it to the second chip.

## Description

This application claims priority to and the benefit of Korean Patent Application No. 10-2025-0051666, filed April, 21, 2025.

### BACKGROUND

### Field

The present disclosure relates to a multi-chip package for improving ESD (Electro-static Discharge) performance and an electronic device having the same.

### Discussion of Related Art

A plurality of chips (Chip 1 and Chip 2) are disposed in a conventional MCP (Multi-Chip Package).

The plurality of chips (Chip 1 and Chip 2) include a first chip (Chip 1) and a second chip (Chip 2).

The first chip (Chip 1) and the second chip (Chip 2) may each have different ESD (Electro-static Discharge) performance. For example, when the first chip (Chip 1) has relatively superior ESD performance (HBM (Human Body Model): 4 kV) and the second chip (Chip 2) has lower ESD performance (HBM (Human Body Model): 2 kV), the final ESD performance of the packaged MCP is matched to that of the chip with the lowest ESD performance, i.e., the second chip (Chip 2, 2 kV).

As described above, since the second chip (Chip 2) with low ESD performance determines the overall ESD performance of the package, there is a problem in that the final ESD performance of the packaged MCP is degraded due to the difference in ESD (Electro-static Discharge) performance between the plurality of chips (Chip 1 and Chip 2).

Furthermore, in products with high ESD requirements, there is a problem in that careful review is required when selecting a KGD (Known Good Die), and addition of external protection circuits must be considered.

### SUMMARY

The present disclosure provides a multi-chip package and an electronic device having the same that are capable of improving ESD performance even if a difference in ESD performance occurs between a plurality of chips disposed in an MCP (Multi-Chip Package).

A multi-chip package according to one embodiment of the present disclosure includes a multi-chip package implemented by wire bonding a first chip and a second chip, wherein the first chip includes: a first power pin electrically connected to a voltage source that generates or supplies a first voltage; a second power pin electrically connected to a voltage source that generates or supplies a second voltage lower than the first voltage; and a third power pin electrically connected to the first power pin, and the first chip is configured to compare the first voltage supplied through the first power pin with a preset reference voltage, and based on the comparison result, is configured to supply the first voltage to the second chip or discharges the first voltage without supplying it to the second chip.In one or more embodiments, the first chip, based on the comparison result, may be configured to provide the first voltage to the second chip, which is electrically connected to the third power pin, using a first path, when the first voltage supplied through the first power pin is determined to be equal to or lower than the reference voltage.

In one or more embodiments, the first chip, based on the comparison result, may be configured to discharge the first voltage using a second path electrically connected to the second power pin without providing the first voltage to the second chip when the first voltage supplied through the first power pin is determined to be higher than the reference voltage.

In one or more embodiments, the first chip may include a first power clamp circuit between the first power pin and the second power pin.

In one or more embodiments, the first chip may be configured to form an impedance lower than a preset impedance in the second path passing through the first power clamp circuit to discharge the first voltage.

In one or more embodiments, the first chip may include a protection circuit between the first power pin and the third power pin.

In one or more embodiments, the first chip, based on the comparison result, may be configured to control the protection circuit to block the first path passing through the protection circuit when the first voltage supplied through the first power pin is determined to be higher than the reference voltage.

In one or more embodiments, the protection circuit may include a switch element configured to operate to block or connect the first path electrically connecting the first power pin and the third power pin in response to the first voltage.

In one or more embodiments, the protection circuit may include a resistor element between the first power pin and the third power pin.

In one or more embodiments, the second chip may include a first power pin electrically connected to the third power pin of the first chip and configured to receive the first voltage; and a second power pin electrically connected to a voltage source that generates or supplies the second voltage.

In one or more embodiments, a second power clamp circuit may be provided between the first power pin of the second chip and the second power pin of the second chip.

In one or more embodiments, the second power clamp circuit may be configured to process a lower voltage than that processed by the first power clamp circuit.

In one or more embodiments, the multi-chip package may be implemented by wire bonding a first chip and a second chip.

In one or more embodiments, the first chip may include a first power clamp circuit built into the first chip and configured to protect an internal circuit of the first chip during an ESD event.

In one or more embodiments, the first chip may include a protection circuit disposed in parallel with the first power clamp circuit and configured to protect an internal circuit of the second chip electrically connected to the first chip during the ESD event.

A multi-chip package according to another embodiment of the present disclosure includes a multi-chip package implemented by wire bonding a first chip and a second chip, wherein the first chip includes: a first power clamp circuit built into the first chip and configured to protect an internal circuit of the first chip during an ESD event; and a protection circuit disposed in parallel with the first power clamp circuit and configured to protect an internal circuit of the second chip electrically connected to the first chip during the ESD event.

In one or more embodiments, the first chip, during the ESD event, may be configured to supply the first voltage to the second chip using a first path passing through the protection circuit when the first voltage supplied to the first chip is determined to be equal to or lower than a reference voltage.

In one or more embodiments, the first chip, during the ESD event, may be configured to control the protection circuit to block the first path and discharge the first voltage using a second path passing through the first power clamp circuit when the first voltage supplied to the first chip is determined to be higher than the reference voltage.

In one or more embodiments, the protection circuit may include a switch element or a resistor element configured to operate to block or connect the first path based on the first voltage supplied to the first chip during the ESD event.

In one or more embodiments, the second chip may include a second power clamp circuit built therein that processes a lower voltage than that processed by the first power clamp circuit.

In another aspect an electronic device is provided having the multi-chip package as described above.

The multi-chip package and the electronic device having the same according to one embodiment of the present disclosure may improve ESD performance by matching the performance to that of the chip with the best ESD performance among a plurality of chips disposed in an MCP.

In addition, the multi-chip package and the electronic device having the same according to one embodiment of the present disclosure may improve product reliability as the ESD performance of a plurality of chips disposed in an MCP is improved.

In addition, the multi-chip package and the electronic device having the same according to one embodiment of the present disclosure may improve customer satisfaction for the product as the ESD performance of a plurality of chips disposed in an MCP is improved.

In addition, the multi-chip package and the electronic device having the same according to one embodiment of the present disclosure may enhance the stability of the MCP by mitigating, through a resistor or switch, or the like, damage to other chips caused by residual charge after zapping one chip among a plurality of chips disposed in the MCP.

The effects of the present disclosure are not limited to the effects mentioned above, and other effects not mentioned may be clearly understood by those skilled in the art from the claims.

### BRIEF DESCRIPTION OF THE DRAWINGS

The above and other objects, features, and advantages of the present disclosure will become more apparent to those of ordinary skill in the art by describing exemplary embodiments thereof in detail with reference to the attached drawings, in which:
FIG. 1 is a block diagram for explaining a multi-chip package of one embodiment of the disclosure.
FIG. 2 is a diagram for explaining the multi-chip package of FIG. 1.
FIG.3 flowchart explaining operation of the multi-chip package of one embodiment.
FIG. 4A is a diagram for explaining a first path based on the operation of the multi-chip package according to one embodiment of the present disclosure.
FIG. 4B is a diagram for explaining a second path based on the operation of the multi-chip package according to one embodiment of the present disclosure.
FIG. 5 is a diagram for explaining a multi-chip package of a first embodiment of the disclosure.
FIG. 6A is a diagram for explaining a first path based on the operation of the multi-chip package according to the first embodiment of the present disclosure.
FIG. 6B is a diagram for explaining a second path based on the operation of the multi-chip package according to the first embodiment of the present disclosure.
FIG. 7 is a diagram for explaining a multi-chip package of a second embodiment of the disclosure.
FIG. 8A is a diagram for explaining a first path based on the operation of the multi-chip package according to the second embodiment of the present disclosure.
FIG. 8B is a diagram for explaining a second path based on the operation of the multi-chip package according to the second embodiment of the present disclosure.
FIG. 9 is a block diagram for explaining at least one multi-chip packages mounted in an electronic device according to an embodiment of the present disclosure.

### DETAILED DESCRIPTION OF EXEMPLARY EMBODIMENTS

The advantages and features of the disclosure and methods for accomplishing the same will be clearly understood from embodiments described below with reference to the accompanying drawings. However, the disclosure is not limited to the following embodiments but may be implemented in various different forms. Rather, the embodiments will make the disclosure of the disclosure complete and allow those skilled in the art to completely comprehend the scope of the disclosure.

The shapes, sizes, ratios, angles, numbers, and the like illustrated in the accompanying drawings for describing the embodiments of the present disclosure are merely examples, and the present disclosure is not limited thereto. Like reference numerals generally denote like elements throughout the specification. Further, in describing the disclosure, detailed descriptions of known related technologies may be omitted to avoid unnecessarily obscuring the subject matter of the disclosure.

The terms such as "comprising," "including," "having," and "consist of" used herein are generally intended to allow other components to be added unless the terms are used with the term "only." Any references to singular may include plural unless expressly stated otherwise.

Components are interpreted to include an ordinary error range even if not expressly stated.

When a positional or interconnected relationship is described between two components, such as "on top of," "above," "below," "next to," "connect or couple with," "crossing," "intersecting," or the like, one or more other components may be interposed between them, unless "immediately" or "directly" is used.

When a temporal antecedent relationship is described, such as "after", "following", "next to", "before", or the like, it may not be continuous on a time base unless "immediately" or "directly" is used.

The terms "first," "second," and the like may be used to distinguish elements from each other, but the functions or structures of the components are not limited by ordinal numbers or component names in front of the components.

The following embodiments can be partially or entirely bonded to or combined with each other and can be linked and operated in technically various ways. The embodiments can be carried out independently of or in association with each other.

In the following embodiments, a transistor is a three-electrode element including a gate, a source, and a drain. In the case of an n-channel transistor, since carriers are electrons, a source voltage is lower than a drain voltage such that electrons may flow from the source to the drain. In the n-channel transistor, the direction of current is from the drain toward the source. In the case of a p-channel transistor (PMOS), since carriers are holes, the source voltage is higher than the drain voltage such that holes may flow from the source to the drain. In the p-channel transistor, since holes flow from the source toward the drain, the current flows from the source toward the drain. It should be noted that the source and the drain of a transistor are not fixed. In the following description, the source and the drain of the transistor will be referred to as a first electrode and a second electrode.

Hereinafter, various embodiments of the present invention will be described in detail with reference to the accompanying drawings.

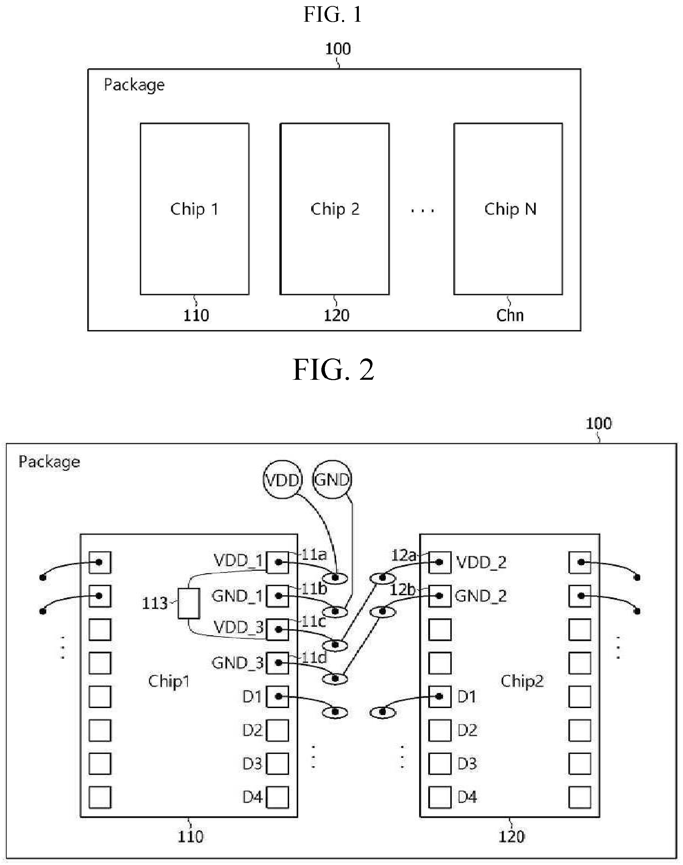

FIG.1 is a block diagram for explaining a multi-chip package according to one embodiment of the present disclosure, and FIG. 2 is a diagram for explaining the multi-chip package of FIG.1.

Referring to FIG. 1, a multi-chip package (Multi-Chip Package, MCP) 100 according to one embodiment of the present disclosure may mount a plurality of chips 110, 120, ..., Chn having different functions in a single package.

Each of the chips 110, 120, ..., Chn in the multi-chip package 100 is attached to a single substrate and electrically connected to each other to perform a single function.

For example, the multi-chip package 100 may include a first chip 110, a second chip 120, ..., and an n-th chip Chn, where n may be a natural number.

Each of the first chip 110 to the n-th chip Chn is interconnected by wire bonding. For convenience of explanation, the present disclosure will be described focusing on the first chip 110 and the second chip 120.

Referring to FIG. 2, the multi-chip package 100 may be implemented by wire bonding the first chip 110 and the second chip 120. The first chip 110 and the second chip 120 may each have at least one pin.

The first chip 110 may include at least one input pin, at least one output pin, at least one power pin, at least one signal pin, and the like. The at least one power pin may include a first power pin (VDD_1) 11a, a second power pin (GND_1) 11b, a third power pin (VDD_3) 11c, and a fourth power pin (GND_3) 11d, and the like. The at least one signal pin may include a first signal pin D1, a second signal pin D2, a third signal pin D3, and a fourth signal pin D4, and the like.

For example, the first chip 110 may include a first power pin (VDD_1) 11a electrically connected to a voltage source that generates or supplies a first voltage, a second power pin (GND_1) 11b electrically connected to a voltage source that generates or supplies a second voltage lower than the first voltage, a third power pin (VDD_3) 11c electrically connected to the first power pin (VDD_1) 11a, and a fourth power pin (GND_3) 11d electrically connected to the second power pin (GND_1) 11b. Here, the first voltage may be referred to as a digital operating voltage, a chip supply voltage, or a VDD voltage, and the second voltage may be referred to as a common ground voltage, a ground (GND) voltage, or a VSS voltage.

The first chip 110 may have a protection circuit 113 capable of protecting the second chip 120, which is electrically connected to the first chip 110, from an ESD event. The protection circuit 113 may be disposed between the first power pin (VDD_1) 11a and the third power pin (VDD_3) 11c. The protection circuit 113 may operate in response to the first voltage supplied through the first power pin (VDD_1) 11a. For example, the protection circuit 113 may supply the first voltage to the second chip 120 or block the first voltage from being supplied to the second chip 120 in response to the first voltage. A detailed description thereof will be provided below.

The second chip 120 may include at least one input pin, at least one output pin, at least one power pin, at least one signal pin, and the like. The at least one power pin may include a first power pin (VDD_2) 12a, a second power pin (GND_2) 12b, a third power pin, a fourth power pin, and the like. The at least one signal pin may include a first signal pin D1, a second signal pin D2, a third signal pin D3, and a fourth signal pin D4, and the like.

For example, the second chip 120 may include a first power pin (VDD_2) 12a electrically connected to the third power pin (VDD_3) 11c of the first chip 110, and a second power pin (GND_2) 12b electrically connected to a voltage source that generates or supplies a second voltage lower than the first voltage. The second power pin (GND_2) 12b of the second chip 120 may be electrically connected to the fourth power pin (GND_3) 11d of the first chip 110.

Although FIG. 2 shows the second power pin (GND_1) 11b of the first chip 110, the fourth power pin (GND_3) 11d of the first chip 110, and the second power pin (GND_2) 12b of the second chip 120 separately, each of these pins may be connected commonly to a ground (GND) voltage.

The first signal pin D1 of the second chip 120 may be electrically connected to the first signal pin D1 of the first chip 110. Although FIG. 2 shows the first signal pin D1 of the second chip 120 being electrically connected to the first signal pin D1 of the first chip 110, this is not limiting, and other signal pins may also be connected or separated in various ways depending on the functions of the chips.

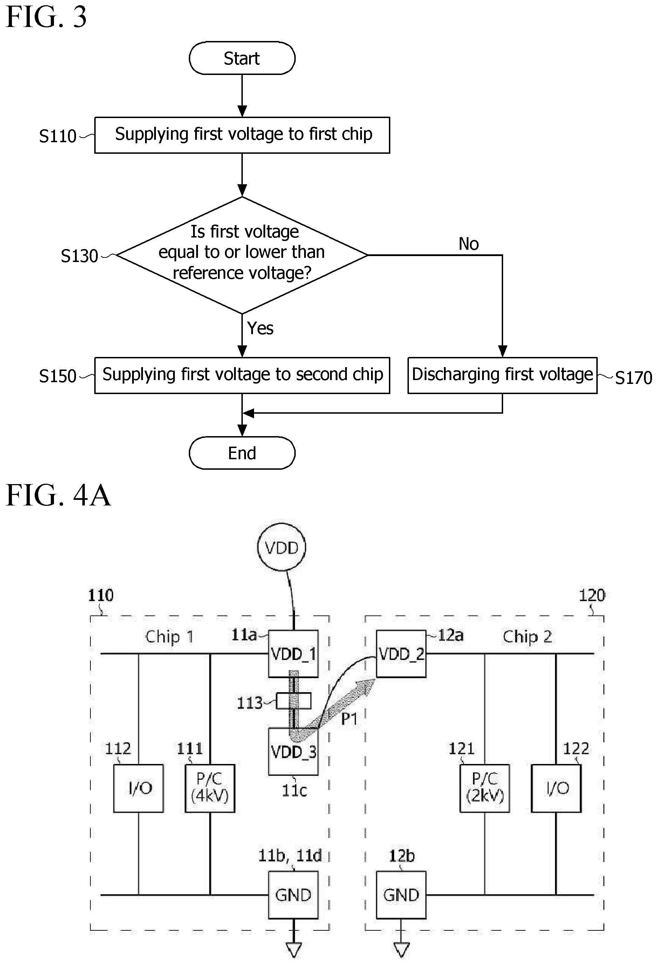

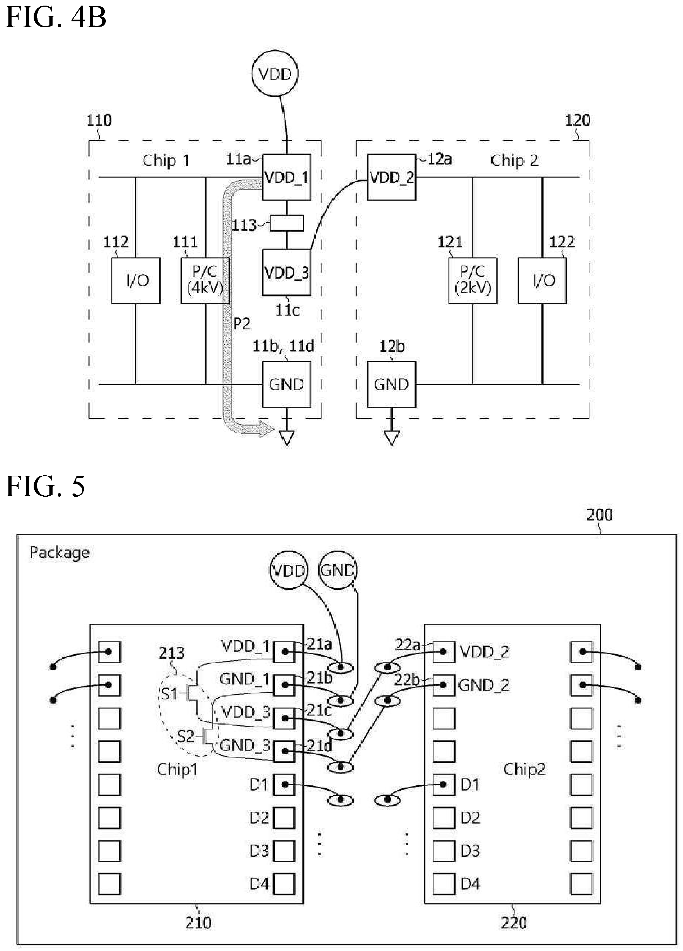

FIG. 3 is a flowchart for explaining the operation of the multi-chip package according to one embodiment of the present disclosure, FIG. 4A is a diagram for explaining a first path based on the operation of the multi-chip package according to one embodiment of the present disclosure, and FIG. 4B is a diagram for explaining a second path based on the operation of the multi-chip package according to one embodiment of the present disclosure.

Referring to FIGS. 3, 4A, and 4B, the multi-chip package 100 according to one embodiment of the present disclosure may include the first chip 110 and the second chip 120.

The first chip 110 may include a first power clamp circuit 111 built into the first chip 110 and configured to protect the internal circuit of the first chip 110 during an ESD event, a protection circuit 113 disposed in parallel with the first power clamp circuit 111 and configured to protect the internal circuit of the second chip 120 electrically connected to the first chip 110 during the ESD event, and a first input/output circuit 112 disposed in parallel with the first power clamp circuit 111 and configured to receive or output signals.

The second chip 120 may include a second power clamp circuit 121 built into the second chip 120 and configured to protect the internal circuit of the second chip 120 during an ESD event, and a second input/output circuit 122 disposed in parallel with the second power clamp circuit 121 and configured to receive or output signals.

Referring to FIG. 3, the first chip 110 may receive a first voltage through the first power pin (VDD_1) 11a (S110).

Upon receiving the first voltage through the first power pin (VDD_1) 11a, the first chip 110 may compare the received first voltage with a preset reference voltage (S130). The reference voltage may be a supply voltage capable of stably operating the first chip 110.

The first chip 110 may, based on the comparison result, supply the first voltage to the second chip 120 or discharge the first voltage without supplying it to the second chip 120. For example, the first chip 110 may, by operating the protection circuit 113 based on the comparison result, supply the first voltage to the second chip 120 or block the first voltage from being supplied to the second chip 120.

For example, when the first chip 110 determines, as a comparison result, that the first voltage supplied through the first power pin (VDD_1) 11a is equal to or lower than the reference voltage (S130), it may provide the first voltage to the first power pin (VDD_2) 12a of the second chip 120 electrically connected to the third power pin (VDD_3) 11c (S150). That is, when the first chip 110 determines that the first voltage supplied to the first chip 110 during an ESD event is equal to or lower than the reference voltage, it may provide the first voltage to the second chip 120 through a first path P1 passing through the protection circuit 113. The first path P1 may be referred to as a voltage path.

When the first voltage is equal to or lower than the reference voltage, the first chip 110 may determine that the first voltage is a voltage able to stably operate the second chip 120. Accordingly, the first chip 110 may stably supply the first voltage to the second chip 120 through the first path P1 passing through the protection circuit 113.

When the first chip 110 determines, based on the comparison result, that the first voltage supplied through the first power pin (VDD_1) 11a is higher than the reference voltage (S130), the first chip 110 may discharge the first voltage without providing the first voltage to the second chip 120 (S170). In other words, when the first chip 110 determines that the first voltage supplied to the first chip 110 during an ESD event is higher than the reference voltage, it may block the first path P1 passing through the protection circuit 113 and discharge the first voltage through a second path P2 passing through the first power clamp circuit 111. The second path P2 may be referred to as a discharge path or a bypass path.

When the first voltage is higher than the reference voltage, the first chip 110 may determine that the first voltage is a voltage that is unable to stably operate the second chip 120. Accordingly, the first chip 110 may block the first path P1 passing through the protection circuit 113 and discharge the first voltage through the second path P2 passing through the first power clamp circuit 111, so as not to supply the first voltage to the second chip 120.

For example, when the first chip 110 of the multi-chip package 100 according to the present disclosure is zapped at 4 kV through the first power pin (VDD_1) 11a, the current is discharged through the first power clamp circuit 111 disposed between the first power pin (VDD_1) 11a and the second power pin (GND_1) 11b, and therefore the second chip 120 having the second power clamp circuit 121 with 2 kV rating may also not be damaged by the 4 kV voltage.

As described above, in the multi-chip package 100 according to the present disclosure, the voltage source that generates or supplies the first voltage is not directly connected to the second chip 120, but the first voltage is provided to the second chip 120 through the first chip 110, thereby preventing a voltage that could damage the second chip 120 from being supplied to the second chip 120.

In the multi-chip package 100 of the present disclosure, the second chip 120, which is an IC with inferior ESD characteristics than the first chip 110, may not be directly wire bonded to an external voltage source, and may be supplied with a stable first voltage through the first chip 110, which has relatively superior ESD characteristics. For example, even though the second power clamp circuit 121 is capable of processing a lower voltage than that processed by the first power clamp circuit 111, the first voltage, which is a high voltage, may be supplied to the second chip 120 through the first chip 110, so that the second chip 120 may be stably protected.

Accordingly, when the ESD performances of the first chip 110 and the second chip 120 differ, unlike a conventional multi-chip package in which the final ESD performance of the packaged chip is inevitably limited by the inferior ESD performance of the two chips, the multi-chip package 100 of the present disclosure may follow the ESD performance of the chip with the relatively superior ESD performance, thereby improving the ESD performance of the multi-chip package 100.

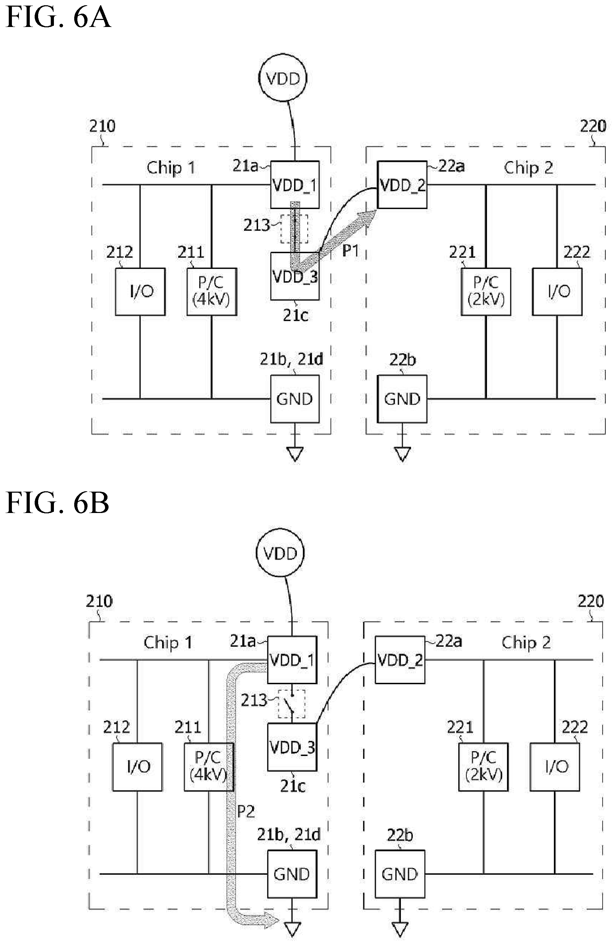

FIG. 5 is a diagram for explaining a multi-chip package according to a first embodiment of the present disclosure, FIG. 6A is a diagram for explaining a first path based on the operation of the multi-chip package according to the first embodiment of the present disclosure, and FIG. 6B is a diagram for explaining a second path based on the operation of the multi-chip package according to the first embodiment of the present disclosure.

Referring to FIG. 5, a multi-chip package 200 may be implemented by wire bonding a first chip 210 and a second chip 220. The first chip 210 and the second chip 220 may each have at least one pin.

The first chip 210 may include a first power pin (VDD_1) 21a, a second power pin (GND_1) 21b, a third power pin (VDD_3) 21c, a fourth power pin (GND_3) 21d, a first signal pin D1, a second signal pin D2, a third signal pin D3, and a fourth signal pin D4.

For example, the first chip 210 may include a first power pin (VDD_1) 21a electrically connected to a voltage source that generates or supplies a first voltage, a second power pin (GND_1) 21b electrically connected to a voltage source that generates or supplies a second voltage lower than the first voltage, a third power pin (VDD_3) 21c electrically connected to the first power pin (VDD_1) 21a, and a fourth power pin (GND_3) 21d electrically connected to the second power pin (GND_1) 21b.

The first chip 210 may have a protection circuit 213 capable of protecting the second chip 220, which is electrically connected to the first chip 210, from an ESD event. The protection circuit 213 may include a first switch element S1 and a second switch element S2.

The first switch element S1 may be disposed between the first power pin (VDD_1) 21a and the third power pin (VDD_3) 21c, and the second switch element S2 may be disposed between the second power pin (GND_1) 21b and the fourth power pin (GND_3) 21d. Each of the first switch element S1 and the second switch element S2 may operate in response to the first voltage supplied through the first power pin (VDD_1) 21a. For example, each of the first switch element S1 and the second switch element S2 may supply the first voltage to the second chip 220 or block the first voltage from being supplied to the second chip 220 in response to the first voltage.

The second chip 220 may include a first power pin (VDD_2) 22a, a second power pin (GND_2) 22b, a third power pin, a fourth power pin, a first signal pin, a second signal pin, a third signal pin, and a fourth signal pin.

For example, the second chip 220 may include a first power pin (VDD_2) 22a electrically connected to the third power pin (VDD_3) 21c of the first chip 210, and a second power pin (GND_2) 22b electrically connected to a voltage source that generates or supplies a second voltage lower than the first voltage. The second power pin (GND_2) 22b of the second chip 220 may be electrically connected to the fourth power pin (GND_3) 21d of the first chip 210.

Although FIG. 5 shows the second power pin (GND_1) 21b of the first chip 210, the fourth power pin (GND_3) 21d of the first chip 210, and the second power pin (GND_2) 22b of the second chip 220 separately, each of these pins may be connected commonly to a ground (GND) voltage.

The first signal pin D1 of the second chip 220 may be electrically connected to the first signal pin D1 of the first chip 210. The present disclosure is not limited thereto, and other signal pins may also be connected or separated in various ways depending on the functions of the chips.

Referring to FIGS. 6A and 6B, the multi-chip package 200 according to the first embodiment of the present disclosure may include the first chip 210 and the second chip 220.

The first chip 210 may include a first power clamp circuit 211 built into the first chip 210 and configured to protect the internal circuit of the first chip 210 during an ESD event, a protection circuit 213 disposed in parallel with the first power clamp circuit 211 and configured to protect the internal circuit of the second chip 220 electrically connected to the first chip 210 during the ESD event, and a first input/output circuit 212 disposed in parallel with the first power clamp circuit 211 and configured to receive or output signals.

The second chip 220 may include a second power clamp circuit 221 built into the second chip 220 and configured to protect the internal circuit of the second chip 220 during an ESD event, and a second input/output circuit 222 disposed in parallel with the second power clamp circuit 221 and configured to receive or output signals.

The first chip 210 may supply the first voltage provided to the first chip 210 to the second chip 220 by controlling the first switch element S1, or may discharge the first voltage without supplying it to the second chip 220.

For example, when the first chip 210 determines that the first voltage supplied through the first power pin (VDD_1) 21a is equal to or lower than the reference voltage, the first chip 210, in response to the first voltage, turns on the first switch element S1 such that the first voltage may be provided to the first power pin (VDD_2) 22a of the second chip 220 electrically connected to the third power pin (VDD_3) 21c. That is, during an ESD event, when the first chip 210 determines that the first voltage supplied to the first chip 210 is equal to or lower than the reference voltage, it may allow the first voltage to be provided to the second chip 220 through the first path P1 passing through the turned-on first switch element S1.

When the first voltage is equal to or lower than the reference voltage, the first chip 210 may determine that the first voltage is a voltage that is able to stably operate the second chip 220. Accordingly, the first chip 210 may stably supply the first voltage to the second chip 220 through the first path P1 passing through the first switch element S1.

When the first chip 210 determines that the first voltage supplied through the first power pin (VDD_1) 21a is higher than the reference voltage, the first chip 210, in response to the first voltage, turns off the first switch element S1, such that the first voltage may be discharged without being provided to the second chip 220. That is, during an ESD event, when the first chip 210 determines that the first voltage supplied to the first chip 210 is higher than the reference voltage, it may turn off the first switch element S1 to block the first path P1, such that the first voltage may be discharged through the second path P2 passing through the first power clamp circuit 211.

When the first voltage is higher than the reference voltage, the first chip 210 may determine that the first voltage is a high voltage that could damage the second chip 220. Accordingly, the first chip 210 turns off the first switch element S1 to block the first path P1, and discharges the first voltage through the second path P2 passing through the first power clamp circuit 211, thereby blocking the first voltage from being supplied to the second chip 220.

In other words, during an ESD test, when the first chip 210 of the multi-chip package 200 of the present disclosure is zapped at 4 kV through the first power pin (VDD_1) 21a, the first switch element S1 is turned off to block the first path P1, so the current is discharged through the first power clamp circuit 211 disposed between the first power pin (VDD_1) 21a and the second power pin (GND_1) 21b. As a result, the second chip 220 having the second power clamp circuit 221 with 2 kV rating may also not be damaged by the 4 kV voltage.

That is, the multi-chip package 200 of the present disclosure may fundamentally block residual charge from passing to the second chip 220 after zapping by turning off the first switch element S1 to block the first path P1, thereby enhancing stability.

Alternatively, in normal operation other than during an ESD test, the first chip 210 of the multi-chip package 200 of the present disclosure may turn on the first switch element S1 to supply the supply voltage of the chip to the second chip 220 through the first path P1.

As described above, the multi-chip package 200 of the present disclosure does not directly connect the voltage source that generates or supplies the first voltage to the second chip 220, but provides the first voltage to the second chip 220 through the first chip 210, thereby preventing a high voltage that could damage the second chip 220 from being supplied to the second chip 220. That is, in the multi-chip package 200 of the present disclosure, the second chip 220, which is an IC with inferior ESD characteristics than the first chip 210, may not be directly wire bonded to an external voltage source, and may be supplied with a stable first voltage through the first chip 210, which has relatively superior ESD characteristics.

Accordingly, when the ESD performances of the first chip 210 and the second chip 220 differ, unlike a conventional multi-chip package in which the final ESD performance of the packaged chip is inevitably limited by the inferior ESD performance of the two chips, the multi-chip package 200 of the present disclosure may follow the ESD performance of the chip with the relatively superior ESD performance, thereby improving the ESD performance of the multi-chip package 200.

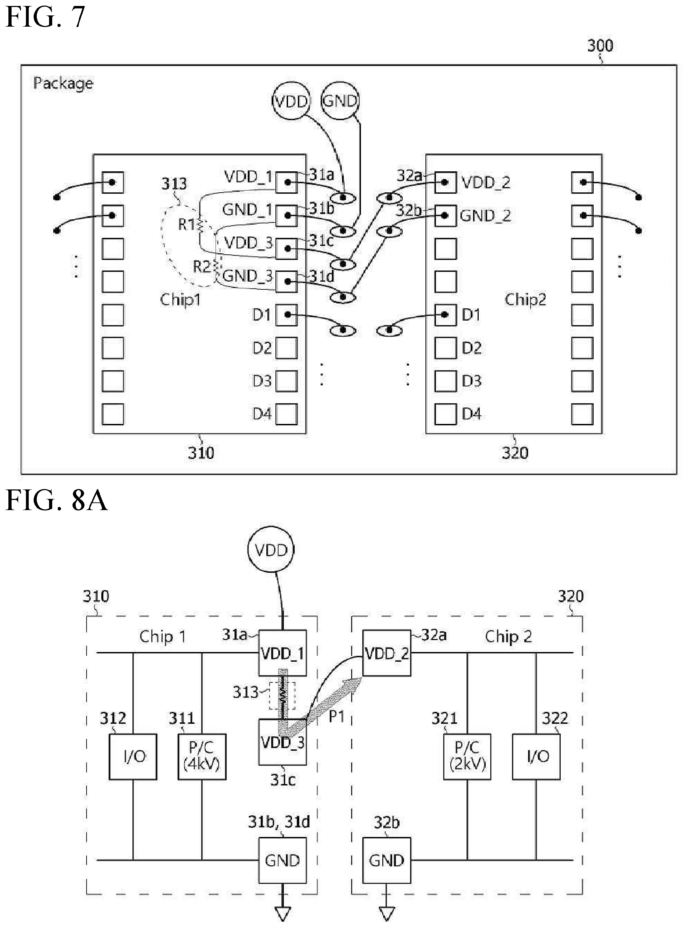

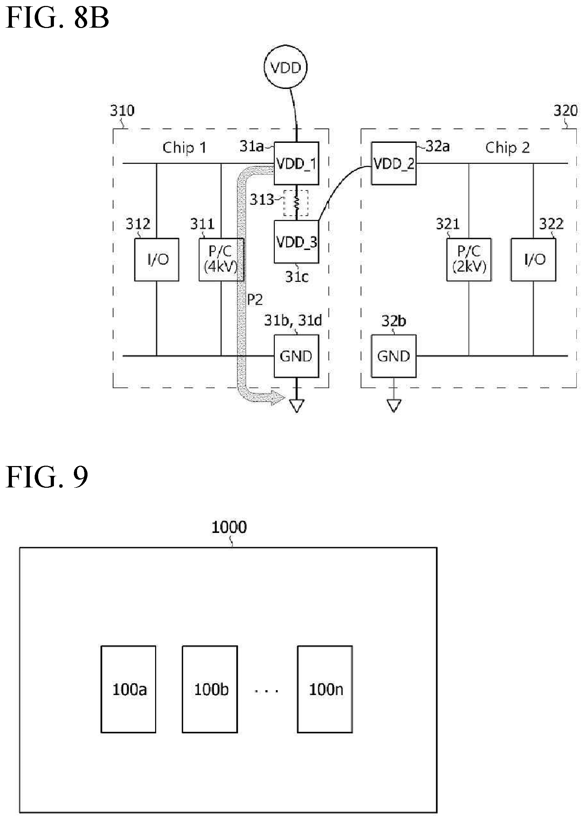

FIG. 7 is a diagram for explaining a multi-chip package according to a second embodiment of the present disclosure, FIG. 8A is a diagram for explaining a first path based on the operation of the multi-chip package according to the second embodiment of the present disclosure, and FIG. 8B is a diagram for explaining a second path based on the operation of the multi-chip package according to the second embodiment of the present disclosure.

Referring to FIG. 7, a multi-chip package 300 may be implemented by wire bonding a first chip 310 and a second chip 320. The first chip 310 and the second chip 320 may each have at least one pin. In FIGS. 7 to 8B, descriptions overlapping with FIGS. 1 to 6B will be omitted.

The first chip 310 may have a protection circuit 313 capable of protecting the second chip 320, which is electrically connected to the first chip 310, from an ESD event. The protection circuit 313 may include a first resistor element R1 and a second resistor element R2.

The first resistor element R1 may be disposed between the first power pin (VDD_1) 31a and the third power pin (VDD_3) 31c, and the second resistor element R2 may be disposed between the second power pin (GND_1) 31b and the fourth power pin (GND_3) 31d.

The first chip 310 may enhance chip stability by mitigating damage to the second chip 320 from residual charge after an ESD event or after zapping through the first resistor element R1 and the second resistor element R2. Here, the first resistor element R1 and the second resistor element R2 may serve as buffers to cushion against instantaneous high voltage being supplied to the second chip 320.

Referring to FIGS. 8A and 8B, the multi-chip package 300 according to the second embodiment of the present disclosure may include the first chip 310 and the second chip 320.

The first chip 310 may include a first power clamp circuit 311, a protection circuit 313, and a first input/output circuit 312.

The second chip 320 may include a second power clamp circuit 321 and a second input/output circuit 322.

The first chip 310 may supply the first voltage applied to the first chip 310 to the second chip 320 through the first resistor element R1 or discharge the first voltage without supplying it to the second chip 320.

When it is not an ESD event, the first chip 310 may provide the first voltage applied to the first chip 310 to the second chip 320 through the first path P1 passing through the first resistor element R1.

During an ESD event, since the impedance of the first path P1 is increased by the first resistor element R1, the first chip 310 may discharge the first voltage, which is a high voltage applied to the first chip 310, along the second path P2 passing through the first power clamp circuit 311, where a relatively lower impedance is formed.

During an ESD event, since the second path P2, which includes the first power clamp circuit 311, instantaneously forms a low impedance path, the first chip 310 may rapidly discharge the first voltage, which is a high voltage, through the second path P2 rather than the first path P1 whose impedance has been increased by the first resistor element R1.

That is, during an ESD event, the first voltage may be rapidly discharged through the low impedance second path P2 rather than the first path P1 whose impedance is increased by the first resistor element R1.

During an ESD event, the second chip 320 may avoid a rapid voltage rise because the first voltage, which is a high voltage, is applied slowly through the first resistor element R1.

Due to the first resistor element R1 disposed in the first chip 310, the high voltage is applied to the second chip 320 for a relatively long period of time, thereby allowing the high voltage to be discharged through the second power clamp circuit.

For example, during an ESD test, when the first chip 310 of the multi-chip package 300 of the present disclosure is zapped at 4 kV through the first power pin (VDD_1) 31a, the 4 kV voltage may be bypassed and discharged through the second path P2, which is the bypass path including the first power clamp circuit 311, due to the first resistor element R1.

The second chip 320 may safely maintain its operation even after an ESD event, since the residual charge after zapping can be discharged using the second power clamp circuit 321.

As described above, the multi-chip package 300 of the present disclosure does not directly connect the voltage source that supplies the first voltage to the second chip 320, but provides the first voltage to the second chip 320 through the first chip 310, thereby preventing a high voltage that could damage the second chip 320 from being supplied to the second chip 320. That is, in the multi-chip package 300 of the present disclosure, the second chip 320, which is an IC with inferior ESD characteristics than the first chip 310, may not be directly wire bonded to an external voltage source, and may be supplied with a stable first voltage through the first chip 310, which has relatively superior ESD characteristics.

Accordingly, when the ESD performances of the first chip 310 and the second chip 320 differ, unlike a conventional multi-chip package in which the final ESD performance of the packaged chip is inevitably limited by the inferior ESD performance of the two chips, the multi-chip package 300 of the present disclosure may follow the ESD performance of the chip with the relatively superior ESD performance, thereby improving the ESD performance of the multi-chip package 300.

FIG. 9 is a block diagram for explaining at least one multi-chip packages mounted in an electronic device according to an embodiment of the present disclosure.

Referring to FIG. 9, one or more multi-chip package (MCPs) 100a, 100b, ..., 100n according to an embodiment of the present disclosure may be mounted in various electronic devices 1000.

For example, the multi-chip packages 100a, 100b, ..., 100n according to one embodiment may be applied to mobile devices, video phones, smart watches, watch phones, wearable devices, foldable devices, rollable devices, bendable devices, flexible devices, curved devices, electronic notebooks, e-books, PMPs (portable multimedia players), PDAs (personal digital assistants), MP3 players, mobile medical devices, desktop PCs, laptop PCs, netbook computers, workstations, navigation systems, vehicle navigation systems, vehicle display devices, televisions, wallpaper display devices, signage devices, gaming devices, notebooks, monitors, cameras, camcorders, and home appliances.

Accordingly, the various electronic devices 1000 with the multi-chip packages 100a, 100b, ..., 100n mounted thereon may minimize EMI/ESD issues caused by chip-to-chip packaging.

In addition, the various electronic devices 1000 with the multi-chip packages 100a, 100b, ..., 100n mounted thereon may be designed to be small and thin in thickness, thereby saving space in the electronic devices.

In addition, the various electronic devices 1000 with the multi-chip packages 100a, 100b, ..., 100n mounted thereon may enable high-speed communication due to shortened distances between chips and may reduce signal delay between chips.

In addition, the various electronic devices 1000 with the multi-chip packages 100a, 100b, ..., 100n mounted thereon may efficiently improve power by facilitating power management and heat control.

In addition, the various electronic devices 1000 with the multi-chip packages 100a, 100b, ..., 100n mounted thereon may simplify board design and may enable process integration, thereby reducing manufacturing costs.

The descriptions of the problem to be solved, the means to solve the problem, and the effect described above do not specify the essential features of the claims, and therefore the scope of the claims is not limited by what is described in the specification.

Although the embodiments of the disclosure have been described in more detail with reference to the accompanying drawings, the disclosure is not necessarily limited to such embodiments, and may be variously modified within the scope thereof without departing from the technical concept of the disclosure. Therefore, the embodiments disclosed in the disclosure are provided for illustrative purposes only and are not intended to limit the technical concept of the disclosure, and the scope of the technical concept of the disclosure is not limited thereto. Therefore, the embodiments described above should be understood in all respects as illustrative and not restrictive.

### List of Reference Numerals

100, 200, 300, 100a, 100b, 100n: Multi-chip package
110, 210, 310: First chip
120, 220, 320: Second chip
111, 211, 311: First power clamp circuit
112, 212, 312: First input/output circuit
113, 213, 313: Protection circuit
121, 221, 321: Second power clamp circuit
122, 222, 322: Second input/output circuit

## Claims

1. A multi-chip package comprising:
a multi-chip package (100) implemented by wire bonding a first chip (110) and a second chip (120),
wherein the first chip (110) includes:
a first power pin (11a) electrically connected to a voltage source that generates or supplies a first voltage;
a second power pin (11b) electrically connected to a voltage source that generates or supplies a second voltage lower than the first voltage; and
a third power pin (11c) electrically connected to the first power pin (11a), and
wherein the first chip (110) is configured to compare the first voltage supplied through the first power pin (11a) with a preset reference voltage, and based on the comparison result, is configured to supply the first voltage to the second chip (120) or discharge the first voltage without supplying it to the second chip (120).

2. The multi-chip package according to claim 1, wherein the first chip (110), based on the comparison result, is configured to provide the first voltage to the second chip (120), which is electrically connected to the third power pin (11c), using a first path, when the first voltage supplied through the first power pin (11a) is determined to be equal to or lower than the reference voltage.

3. The multi-chip package according to claim 1 or 2, wherein the first chip (110), based on the comparison result, is configured to discharge the first voltage using a second path electrically connected to the second power pin (11b) without providing the first voltage to the second chip (120) when the first voltage supplied through the first power pin (11a) is determined to be higher than the reference voltage.

4. The multi-chip package according to any one of the preceding claims, wherein:
the first chip (110) includes a first power clamp circuit (111) between the first power pin (11a) and the second power pin (11b), and
the first chip (110) is configured to form an impedance lower than a preset impedance in the second path passing through the first power clamp circuit (111) to discharge the first voltage.

5. The multi-chip package according to any one of the preceding claims, wherein the first chip (110) includes a protection circuit (113) between the first power pin (11a) and the third power pin (11c).

6. The multi-chip package according to claim 5, wherein the first chip (110), based on the comparison result, is configured to control the protection circuit (113) to block the first path passing through the protection circuit (113) when the first voltage supplied through the first power pin (11a) is determined to be higher than the reference voltage.

7. The multi-chip package according to claim 5 or 6, wherein the protection circuit (113) includes a switch element (S1, S2) configured to operate to block or connect the first path electrically connecting the first power pin (11a) and the third power pin (11c) in response to the first voltage.

8. The multi-chip package according to claim 5, 6 or 7, wherein the protection circuit (113) includes a resistor element (R1, R2) between the first power pin (11a) and the third power pin (11c).

9. The multi-chip package according to any one of the preceding claims 4-8, wherein the second chip (120) includes:
a first power pin (12a) electrically connected to the third power pin (11c) of the first chip (110) and configured to receive the first voltage; and
a second power pin (12b) electrically connected to a voltage source that generates or supplies the second voltage, and
wherein a second power clamp circuit (121) is provided between the first power pin (12a) of the second chip (120) and the second power pin (12b) of the second chip (120), and the second power clamp circuit (121) is configured to process a lower voltage than that processed by the first power clamp circuit (111).

10. A multi-chip package (100) comprising:
a multi-chip package implemented by wire bonding a first chip (110) and a second chip (120),
wherein the first chip (120) includes:
a first power clamp circuit (111) built into the first chip (110) and configured to protect an internal circuit of the first chip (110) during an ESD (Electro-static Discharge) event; and
a protection circuit (113) disposed in parallel with the first power clamp circuit (111) and configured to protect an internal circuit of the second chip (120) electrically connected to the first chip (110) during the ESD event.

11. The multi-chip package according to claim 10, wherein the first chip (110), during the ESD event, is configured to supply the first voltage to the second chip (120) using a first path passing through the protection circuit (113) when the first voltage supplied to the first chip (110) is determined to be equal to or lower than a reference voltage.

12. The multi-chip package according to claim 10 or 11, wherein the first chip (110), during the ESD event, is configured to control the protection circuit (113) to block the first path and discharge the first voltage using a second path passing through the first power clamp circuit (111) when the first voltage supplied to the first chip (110) is determined to be higher than the reference voltage.

13. The multi-chip package according to any one of the claim 10, 11 or 12, wherein the protection circuit (113) includes a switch element (S1, S2) or a resistor element (R1, R2) configured to operate to block or connect the first path based on the first voltage supplied to the first chip (110) during the ESD event.

14. The multi-chip package according to claim 12, wherein the second chip (120) includes a second power clamp circuit (121) built therein that processes a lower voltage than that processed by the first power clamp circuit (111).

15. An electronic device having the multi-chip package (100) according to any one of claims 1 to 14.
